Europäisches Patentamt

European Patent Office

Office européen des brevets

(11) Veröffentlichungsnummer: **0 246 351**
**B1**

(12) **EUROPÄISCHE PATENTSCHRIFT**

(45) Veröffentlichungstag der Patentschrift:
**07.12.88**

(21) Anmeldenummer: **86107040.7**

(22) Anmeldetag: **23.05.86**

(51) Int. Cl.⁴: **H 03 K 5/26**, H 03 K 19/21

(54) **Impulsflankenkoinzidenzdetektor und Verwendung zur Auswahl eines Abtastsignals.**

(43) Veröffentlichungstag der Anmeldung:
**25.11.87 Patentblatt 87/48**

(45) Bekanntmachung des Hinweises auf die Patenterteilung:
**07.12.88 Patentblatt 88/49**

(84) Benannte Vertragsstaaten:
**DE FR NL**

(56) Entgegenhaltungen:
**US-A- 4 229 699**

(73) Patentinhaber: **Deutsche ITT Industries GmbH, Hans-Bunte-Strasse 19 Postfach 840, D-7800 Freiburg (DE)**

(72) Erfinder: **Woods, Brian, Markgrafenstrasse 18, D-7819 Denzlingen (DE)**

(74) Vertreter: **Morstadt, Volker, Dipl.-Ing., c/o Deutsche ITT Industries GmbH Patent/Lizenzabtellung Postfach 840 Hans-Bunte-Strasse 19, D-7800 Freiburg/Brsg. (DE)**

# Beschreibung

Bei der Verarbeitung serieller Datensignale ist sorgfältig darauf zu achten, dass im Interesse der Eindeutigkeit eine Koinzidenz der Flanke des Datensignals mit der Flanke des Abtastsignals des Datenverarbeitungssystems verhindert ist. Beim Auftreten solcher Koinzidenzen treten nämlich Störungen durch sogenannte «glitches» auf. Nach der US-A 4 229 699 wird daher aus beispielsweise zwei Abtastsignalen dasjenige ausgewählt, dessen Flanke nicht mit den Flanken des Datensignals zusammenfällt.

Bei einer Realisierung von Datenverarbeitungssystemen in Form von integrierten Festkörperschaltungen ist zunächst einmal eine monolithisch integrierbare Schaltung zur Feststellung solcher Koinzidenzen erforderlich, welche ein Signal zur Verfügung stellt, das einen Vorgang zur Messung der gegenseitigen Phasenlage von Abtast- und Datensignalen auslöst oder auch ein Signal zum Umschalten auf ein geeignetes Abtastsignal zur Verfügung stellt.

Aufgabe der Erfindung ist daher die Angabe einer mit geringem Flächenbedarf an Halbleitermaterial integrierbaren Schaltungsanordnungen zur Gewinnung von Koinzidenzimpulsen beim Auftreten der Koinzidenz der abfallenden Impulsflanken eines digitalen Datensignals mit den abfallenden Flanken von Abtastsignalen eines digitalen Datenverarbeitungssystems.

Die Erfindung betrifft somit eine integrierbare Schaltungsanordnung gemäss dem Oberbegriff des Anspruchs 1.

Die oben genannte Aufgabe wird erfindungsgemäss durch die im kennzeichnenden Teil des Anspruchs 1 angegebene Schaltungsanordnung gelöst.

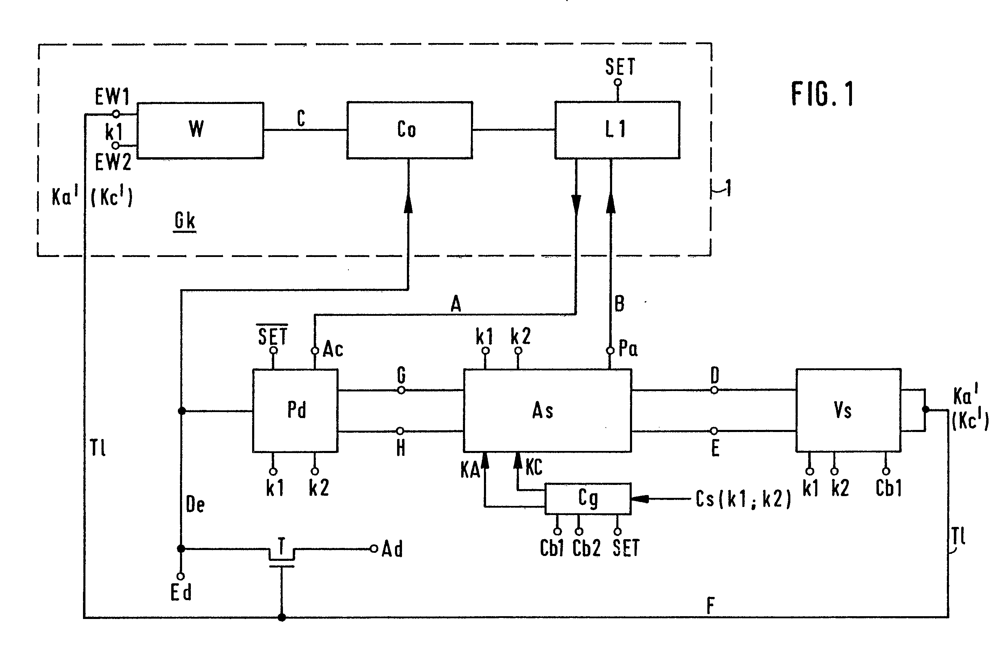

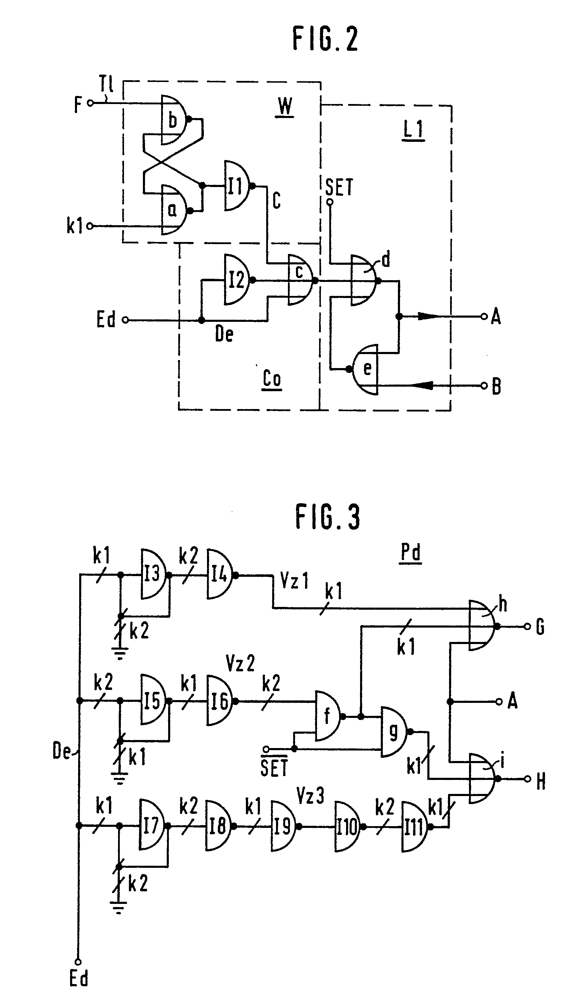

Die integrierbare Schaltungsanordnung nach der Erfindung und deren bevorzugten Verwendung in einer Auswahlschaltung zur Auswahl eines geeigneten Abtastsignals, welches sich durch eine Nichtflankenkoinzidenz mit einem Datensignal auszeichnet, wird im folgenden anhand der Zeichnung erläutert,

deren Fig. 1 das Blockschaltbild einer Auswahlschaltung zeigt, in der die integrierbare Schaltungsanordnung zur Aktivierung eines Phasendetektors verwendet wird,

deren Fig. 2 die integrierbare Schaltungsanordnung nach der Erfindung zeigt,

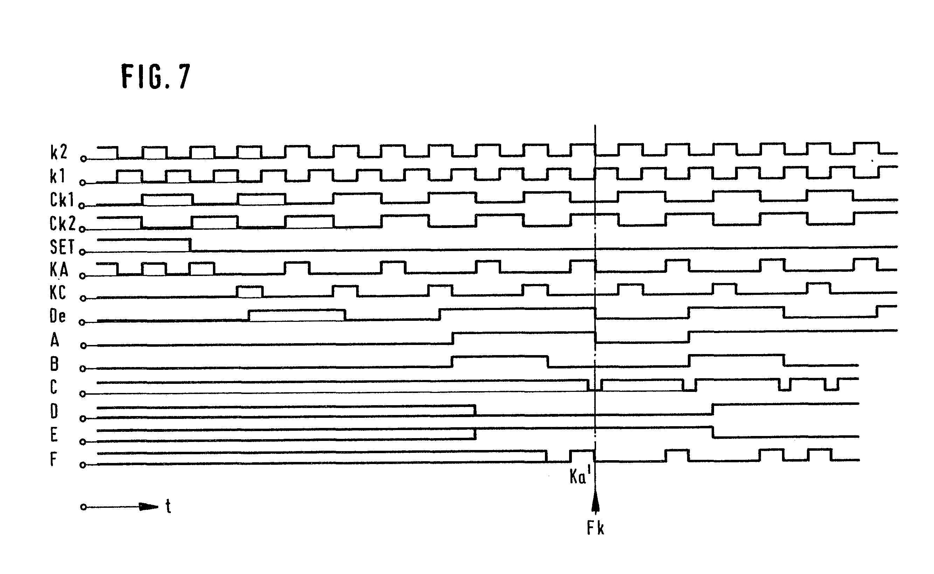

deren Fig. 3 bis 6 weitere Schaltbilder betreffen, wie sie als Blöcke in der Fig. 1 dargestellt sind und

deren Fig. 7 zur Veranschaulichung der Wirkungsweise der Auswahlschaltung der Fig. 1 dient.

Die integrierbare Schaltung zur Gewinnung von Koinzidenzimpulsen beim Auftreten der Koinzidenz der abfallenden Impulsflanken eines digitalen Datensignals mit den abfallenden Flanken eines Abtastsignals, kurz als Flankenkoinzidenzdetektor bezeichnet, umfasst die mit W und Co bezeichneten Blöcke der Fig. 1 bzw. die in gleicher Weise markierten Flächen der Fig. 2.

Die Abtastsignale Ka' bzw. Kc', welche zur Steuerung des Datenverarbeitungssystems erforderlich sind, liegen gemäss der Fig. 1 auf der Taktleitung T1, welche mit der Gateelektrode des getakteten Transistoren bzw. Schalter des Datenverarbeitungssystems mit dem Dateneingang Ed und dem Datenausgang Ad ist.

Der Flankenkoinzidenzdetektor nach der Erfindung weist ein Eingangsgatter auf, welches aus zwei kreuzgekoppelten NOR-Gattern a und b besteht. Die Taktleitung T1 ist mit dem ersten Eingang dieses Eingangsgatters verbunden, während am zweiten Eingang das eine Systemtaktsignal eines zweiphasigen Systemtakts liegt. In der Fig. 7 sind diese beiden Systemtaktsignale k1, k2 zuoberst angegeben. Die unterste Reihe veranschaulicht das Taktsignal F, welches beim Ausführungsbeispiel der Verwendung der integrierbaren Schaltungsanordnung nach der Erfindung vom Abtastsignal Ka' auf das Abtastsignal Kc' umschaltbar ist.

Beträgt die Verzögerungszeit des ersten NOR-Gatters b, an dem das Abtastsignal Ka' bzw. Kc' liegt, etwa das Dreifache der Verzögerungszeit des anderen zweiten NOR-Gatters a, so wird am Ausgang des Inverters I1, dessen Eingang mit dem Ausgang des zweiten NOR-Gatters a verbunden ist, das Signal C gemäss der Fig. 7 erhalten, d.h. eine Impulsfolge, welche sich durch kurze Nullpegel gleicher Dauer auszeichnet. Diese kurze Nullpegel öffnen im Schaltkreis Co ein Messfenster am ersten Eingang des dritten NOR-Gatters c für die an den beiden anderen Eingängen auftretenden Signale, da vom Ausgang des dritten NOR-Gatters c her gesehen nur innerhalb dieses Messfensters Pegelunterschiede am zweiten und dritten Eingang dieses NOR-Gatters c wahrgenommen werden können. Die Ausbildung dieser Messfenster beruht darauf, dass der beispielsweise durch das Abtastsignal Ka' verursachte Potentialanstieg am Eingang des ersten Inverters I1 aufgrund der relativ grossen Verzögerungszeit des NOR-Gatters b relativ langsam erfolgt, dann aber abrupt vom Systemtaktsignal k1 beendet wird, sobald ein gewisser Schwellwert des Eingangsgatters a, b unterschritten wird.

Bei dem Ausführungsbeispiel einer integrierbaren Schaltungsanordnung nach der Erfindung gemäss der Fig. 2 liegt das Datensignal De am zweiten Eingang des dritten NOR-Gatters c und invertiert an dessen dritten Eingang über ein Verzögerungsglied. Dieses kann in Form eines einfachen Inverters I2 realisiert werden. Es ergibt sich also die Möglichkeit, innerhalb des Messfensters des Signals C die abfallende Flanke des Datensignals De zu bestimmen, da nur kurzzeitig an allen drei Eingängen des dritten NOR-Gatters c das Nullpotential unmittelbar hinter der abfallenden Impulsflanke des Datensignals liegt. Die Messgenauigkeit hinsichtlich der relativen Lagen der abfallenden Impulsflanken kann über das Verhältnis der Verzögerungszeiten der NOR-Gatter a und b sowie über die Verzögerungszeit des Verzögerungsgliedes beeinflusst werden.

Im Rahmen der Erfindung liegt natürlich auch die Anwendung der De-Morgan-Gesetze, wonach die Funktionen eines NOR-Gatters durch die Funktionen eines AND-Gatters mit negierten Eingangssignalen realisiert werden kann. Dies bedeutet, dass abweichend von der Schaltungsanordnung der Fig. 1 anstelle eines NOR-Gatters ein AND-Gatter mit drei Eingängen verwendet wird, an dessen erstem Eingang unmittelbar der Ausgang des zweiten NOR-Gatters a angeschlossen ist, am zweiten Eingang des AND-Gatters das Datensignal und an dessen drittem Eingang das invertierte Datensignal verzögert liegt.

Am Ausgang der aus den beiden Schaltkreisen W und Co gebildeten Anordnung der Fig. 2 wird also bei Impulsflankenkoinzidenz kurzzeitig ein auf hohem Pegel liegendes Signal erhalten, welches bei Abwesenheit der Koinzidenz fehlt. Es ist zweckmässig, dieses Koinzidenzsignal in einem ersten Speicherflipflop L1 zu speichern, um bei Verwendung des Flankenkoinzidenzdetektors nach der Erfindung innerhalb einer Auswahlschaltung von Abtastimpulsen die Möglichkeit einer kurzzeitigen Phasenmessung mittels eines Phasendetektors zu geben, dessen Schaltbild in der Fig. 3 angegeben ist. Das Speicherflipflop L1 ist aus den beiden NOR-Gattern d, e aufgebaut, deren Ausgänge wie üblich über Kreuz mit je einem Eingang des anderen NOR-Gatters verbunden sind. Das eine NOR-Gatter d erhält einen dritten Eingang, nämlich einen Setzeingang, an den gemäss der Fig. 7 zur Einleitung der Phasenmessung mittels des Phasendetektors Pd das Setzsignal SET = Null angelegt wird. Am Ausgang des vierten NOR-Gatters d kann ein Aktivierungssignal A für den Phasendetektor Pd abgegriffen werden. Damit ist die integrierbare Schaltungsanordnung nach der Erfindung, wie sie in der Fig. 1 durch die Blöcke W und Co innerhalb des Kastens 1 ersichtlich ist, einschliesslich des Speicherflipflops L1 beschrieben.

Im folgenden wird an einem Ausführungsbeispiel im einzelnen auf die bevorzugte Verwendung der integrierbaren Schaltungsanordnung nach der Erfindung in einer Auswahlschaltung zur Auswahl eines von zwei Abtastsignalen, deren Flanken nicht mit den Flanken des Datensignals koinzidiert, näher eingegangen.

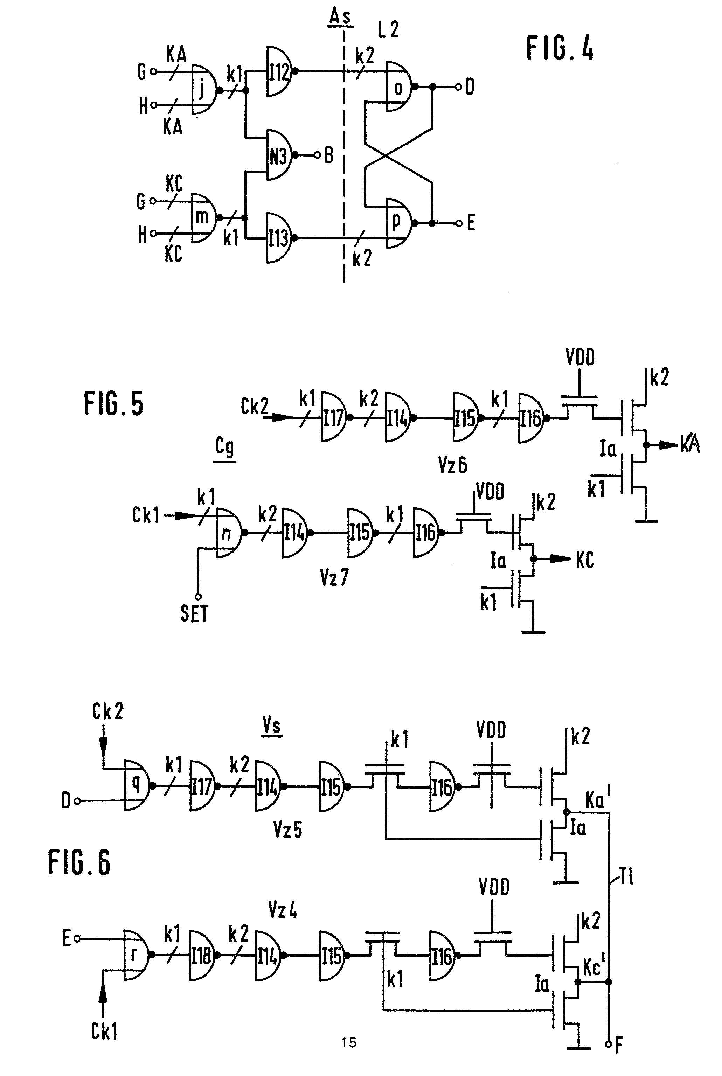

Diese Auswahlschaltung ist ausserhalb des gestrichelten Kastens 1 als Blockschaltbild in der Fig. 1 dargestellt. Sie enthält den Phasendetektor Pd, dessen Schaltbild in der Fig. 3 angegeben ist, den Auswahlschaltkreis As, dessen Schaltung in der Fig. 4 angegeben ist, und die Verzögerungsanordnung Vs, deren Schaltung die Fig. 6 zeigt. Zur Taktung des Auswahlschaltkreises As ist ein in der Fig. 7 angegebener zweiphasiger Takt KA und KC erforderlich, der im Taktgenerator Cg aus dem zweiphasigen Systemtakt Cs und dem zweiphasigen Grundtakt Ck1, Ck2 auf das Setzsignal SET folgend erzeugt wird. Sämtliche Blöcke der Auswahlschaltung erhalten die zweiphasigen Systemtaktsignale k1, k2, wie es aus der Fig. 1 ersichtlich ist. Diese steuern Schalter, welche in den Fig. 3 bis 6 mittels die Leitungen kreuzender Striche angedeutet sind, an denen die Bezugszeichen k1 bzw. k2 angegeben sind. Bei einer Auslegung in MOS-Technik werden diese Schalter durch MOS-Feldeffekttransistoren realisiert, an deren Gateelektroden die entsprechenden Systemtaktsignale liegen.

Die in Fig. 3 gezeigte Schaltung des Phasendetektors Pd weist einen Aktivierungseingang auf, an dem das Aktivierungssignal A liegt, dessen Nullpegel die aktivierenden sind. Der Phasendetektor Pd wird durch die Verwendung von zwei Dreifach-NOR-Gattern h, i aktiviert, indem an die dritten Eingänge jedes der Gatter das Aktivierungssignal A angelegt wird.

Der Phasendetektor Pd enthält im Prinzip eine Mehrzahl von in ihren Laufzeiten abgestuften und von den Systemtaktsignalen k1, k2 getakteten Verzögerungsleitungen, welche ein erstes Paar von Verzögerungsleitungen relativ kleiner Laufzeiten und ein zweites Paar von Verzögerungsleitungen relativ grosser Laufzeiten bilden. Die erste Verzögerungsleitung Vz1 enthält gemäss der Fig. 3 lediglich zwei Inverter I3 und I4, deren Eingänge über Schalter zugänglich sind, über die, wie aus der Fig. 3 ersichtlich ist, vom Dateneingang Ed her das Datensignal De liegt.

Bei einer Flankenkoinzidenz Fk von Datensignal De und einem Abtastsignal Ka' setzt gemäss der Fig. 7 das Aktivierungssignal A = Null die beiden NOR-Gatter h und i in die Lage, den ersten Null-Eins-Datenübergang anzunehmen und seine Lage relativ zu den Systemtaktsignalen k1 und k2 zu ermitteln, sobald die Gesamtanordnung gesetzt ist durch SET = Null am Speicherflipflop L1 und SET = Eins an den beiden NAND-Gattern f und g der zweiten Verzögerungsleitung Vz2 des Phasendetektors Pd der Fig. 3. Der Zweck der Möglichkeit, die zweite Verzögerungsleitung Vz2 zu setzen, besteht lediglich in einer Verbesserung der Prüfmöglichkeit der gesamten Anordnung.

Die zweite Verzögerungsleitung Vz2 enthält wie die erste Verzögerungsleitung Vz1 ebenfalls zwei Inverter I5 und I6, wobei jedoch der erste Inverter I5 dieser Verzögerungsleitung Vz2 das Datensignal De beim Systemtaktsignal k2 erhält. Anstelle der NAND-Gatter f und g können Inverter verwendet werden, falls auf eine Testmöglichkeit verzichtet wird. Bei der zweiten Verzögerungsleitung Vz2 handelt es sich offensichtlich um eine angezapfte Verzögerungsleitung, die zwei Verzögerungsleitungen gleicher Verzögerungszeit ersetzt und die dem NOR-Gatter i ein Signal zuführt, was gegenüber demjenigen des NOR-Gatters h invertiert ist. Die Verzögerungsleitung Vz2 liefert im übrigen während der Impulse des Systemtaktsignals k1 ein Eingangssignal, welches um das Anderthalbfache gegenüber demjenigen der ersten Verzögerungsleitung Vz1 verzögert ist. Natürlich können anstelle der angezapften Verzögerungsleitung Vz2 zwei Verzögerungsleitungen verwendet werden, welche zum Systemtaktsignal k2 ihre Eingangssignale erhalten und während des Systemtaktsignals k1 Ausgangssignale an die beiden NOR-Gatter h, i liefern.

Der Phasendetektor Pd enthält ferner noch eine dritte Verzögerungsleitung Vz3 welche an ihrem Ausgang an das NOR-Gatter i ein Ausgangssignal liefert, welches um das Doppelte der Verzögerungszeit der ersten Verzögerungsleitung Vz1 verzögert, jedoch um 180° in der Phase mittels des Inverters I10 gedreht ist, an dessen Eingang kein Schalter liegt und der deshalb keinen Beitrag zur Verzögerungszeit liefert.

Die Ausgänge der ersten Inverter der Verzögerungsleitungen des Phasendetektors sind noch zur Pegelbegrenzung mit der Gateelektrode je eines nicht weiter gekennzeichneten Feldeffekttransistors verbunden, dessen Schaltstrecke einerseits am Invertereingang und andererseits über einen Schalter mit Masse verbunden ist, der mit demjenigen Systemtaktsignal geschaltet wird, welches den am Ausgang des betreffenden Inverters liegenden Schalter taktet. Der Phasendetektor Pd der Fig. 3 weist die Eigentümlichkeit auf, dass er kurzzeitig während einer Taktperiode der Systemtaktsignale k1, k2 an den beiden Ausgängen G und H die Signalkombination G = Eins, H = Null liefert, falls die abfallende Flanke des Datensignals De während k1 erfolgt und dass er die Signalkombination G = Null, H = Eins liefert, falls dieser Datenwechsel während k2 erfolgt. Damit ergibt sich die Möglichkeit der Auswahl eines geeigneten Abtastsignals aus zwei zur Verfügung stehenden.

Zur Gewinnung dieser zur Auswahl gestellten Abtastsignale Ka' und Kc' werden Verzögerungsschaltkreise verwendet, wie sie sowohl in der Verzögerungsanordnung Vs der Fig. 6 als auch zur Gewinnung der Taktsignale KA und KC im Taktgenerator Cg der Fig. 5 verwendet werden. Die Verzögerungsleitungen Vz6 und Vz7 des Taktgenerators Cg der Fig. 5 sowie die Verzögerungsleitungen Vz4 und Vz5 der Verzögerungsanordnung Vs der Fig. 6 mit den Invertern I14 bis I16 weisen an ihren Ausgängen je einen Ausgangsinverter Ia auf. Zu dessen Spannungsversorgung dient das zweite Systemtaktsignal k2, während der dazu in Reihe liegende Schalttransistor vom ersten Systemtaktsignal k1 angesteuert wird. Die Ausgänge der Ausgangsinverter der Verzögerungsanordnung Vs sind mit der Taktleitung T1 verbunden und damit mit dem ersten Eingang des Eingangsgatters der integrierbaren Schaltungsanordnung nach der Erfindung.

Zur Taktversorgung wird, von den Systemtaktsignalen k1, k2 ausgehend, durch einfache Frequenzteilung der Grundtakt mit den Grundtaktsignalen Ck1 und Ck2 erzeugt. Das zweite Grundtaktsignal Ck2 wird über den Eingangsinverter I17 in die Verzögerungsleitung Vz6 während der Impulse des Systemtaktsignals k2 eingespeist. Dies erfolgt bei der Verzögerungsleitung Vz7 über den ersten Eingang des Eingangsgatters n, wodurch die Möglichkeit gegeben ist, das Taktsignal KC erst nach Anlegen des Setzsignals SET = Null zu aktivieren. Die beiden Taktsignale KA und KC des Taktgenerators Cg dienen dazu, die an den Ausgängen des sechsten und des siebten NOR-Gatters h, i liegenden Schalter leitend zu steuern. Die Ausgänge dieser beiden NOR-Eingangsgatter j, m sind über vom Systemtaktsignal k1 leitend steuerbare Schalter mit den beiden Eingängen des NAND-Gatters N3 verbunden. Dieses bildet an seinem Ausgang den Pegel «1» des Rücksetzsignals B, sobald die Ausgangssignale der beiden NOR-Gatter unterschiedlich (oder auch Null) sind, d.h. sobald angezeigt ist, bei welchem Systemtaktsignale k1 oder k2 der Datenwechsel erfolgt ist. Diese Information wird während der Impulse des Systemtaktsignals k2 in das Speicherflipflop L2 eingegeben, das die zwei kreuzgekoppelten NOR-Gatter o, p enthält. Die im Speicherflipflop L2 gespeicherte Information dient zur Auswahl eines der beiden Abtastsignale Ka' bzw. Kc'. Zu diesem Zweck steht am ersten Ausgang das erste Ausgangssignal E und am zweiten das dazu invertierte zweite Ausgangssignal D gemäss der Fig. 7 zur Verfügung, die an je einem ersten Eingang eines der beiden NOR-Eingangsgatter g, r der Verzögerungsanordnung Vs gemäss der Fig. 6 liegen. Zur näheren Erläuterung wird auf die Fig. 7 verwiesen. Dort ist das Ereignis einer Flankenkoinzidenz mit Fk verzeichnet, wobei die abfallende Flanke des Datensignals De mit der abfallenden Flanke des gerade vorhandenen Abtastsignals Ka' zusammenfällt. Dieses Abtastsignal Ka' tritt am Ausgang der Verzögerungsleitung Vz5 der Verzögerungsanordnung Vs auf, da bei dieser Verzögerungsleitung aufgrund von D = Null am ersten Eingang des NOR-Eingangsgatters q ein Nullpotential liegt. Sogleich nach dieser Koinzidenz ergibt sich eine Aktivierung des Phasendetektors Pd durch A = Null.

Der Phasendetektor liefert dann zu bestimmten aufeinanderfolgenden k1-Systemtaktsignalen zwar ein binäres Signal G, H, welches die Information enthält, bei welchem Systemtaktsignal k1 bzw. k2 eine Flankenkoinzidenz auftritt. Zur Umschaltung auf das nichtkoinzidierende der beiden Abtastsignale Ka' bzw. Kc' ist diese Information aber noch zu synchronisieren, da nur zu ganz bestimmten, nicht mit den Takten KA bzw. KC gleichzeitigen Impulsen des Systemtaktsignals k1 eine eindeutige Zuordnung für die richtige Umschaltung auf einer der beiden geeigneten Binärwerte Null/Eins oder Eins/Null erhalten wird.

Zur Gewinnung dieser geeigneten Binärwerte dienen die beiden NOR-Eingangsgatter j und m des Auswahlschaltkreises As. Die Eingänge dieser NOR-Eingangsgatter j, m liegen über Schalter, die bei den Takten KA und KC leitend geschaltet werden, an den Ausgängen des sechsten bzw. siebten NOR-Gatters h, i, wie die Fig. 3 und 4 erkennen lassen. Die Takte KA und KC werden im Taktgenerator Cg der Fig. 5 erzeugt. Eine solche Taktung hat zur Folge, dass die beiden geeigneten Binärwerte Null/Eins oder Eins/Null erhalten werden, da deren erster Wert aus einer NOR-Bildung bei einem bestimmten Impuls des KA-Taktes und der zweite Binärwert bei dem folgenden Impuls des KC-Taktes als Ausgangssignale G, H der beiden NOR-Gatter h und i entsteht.

Es ist zu bemerken, dass gemäss der Fig. 3 die erste Verzögerungsleitung Vz1 die abfallende Flanke des Datensignals De um einen vollen Takt verzögert nichtinvertiert überträgt. Da der Eingangsschalter der zweiten Verzögerungsleitung Vz2 vom Systemtaktsignal K2 leitend gesteuert wird, erfolgt eine invertierende Übertragung des Eingangssignals um zwei Taktperioden verzögert und invertiert auf das NOR-Gatter h und nichtinvertiert auf das NOR-Gatter i, da vor diesem NOR-Gatter i zusätzlich das invertierende NAND-Gatter g liegt. Die Signalübertragung der dritten Verzögerungsleitung Vz3 auf dieses NOR-Gatter i erfolgt invertierend und um zwei Taktperioden verzögert, da in deren Signalweg der zusätzliche Inverter I10 liegt, vor dessen Eingang kein Schalter im Signalweg angeordnet ist.

Die Ausgangssignale D bzw. E schalten den in Form je eines NOR-Gatters ausgebildeten Eingangsschaltkreis q bzw. r der Verzögerungsanordnung Vs der Fig. 6. Entsprechend dem zugeordneten Ausgangssignal F wird in das entsprechende NOR-Eingangsgatter q bzw. r der zweiphasige Grundtakt Ck1 bzw. Ck2 eingespeist, der aus den Systemtaktsignalen k1, k2 durch Frequenzteilung abgeleitet worden ist, wie die Fig. 7 veranschaulicht. Am Ausgang der beiden Verzögerungsleitungen Vz5 bzw. Vz4 liegt je ein Ausgangsinverter Ia, zu dessen Spannungsversorgung das zweite Systemtaktsignal k2 dient. Der Schalttransistor, dessen Sourceelektrode an Masse liegt, ist vom ersten Systemtaktsignal k1 angesteuert, so dass eine Bootstrapanordnung gegeben ist. Der Ausgang jedes der Inverter Ia ist mit der Taktleitung T1 verbunden. Die Verzögerungsleitungen Vz4 und Vz5 weisen die gleichen Verzögerungszeiten und die gleichen Ausgangsinverter auf, wie die sechste bzw. siebte Verzögerungsleitung Vz6, Vz7 des Taktgenerators Cg der Fig. 5, welche zur Gewinnung der Takte KA und KC dienen. Die Verzögerungsleitungen dienen lediglich zur Verbesserung der Synchronisation.

Die Frequenz der Systemtaktsignale ist gleich dem Zweifachen der Datenrate zu bemessen, d.h. die minimale Pulsbreite des Datensignals ist gleich den zweifachen des Systemtakts. Die Frequenz der Takte KA, KC bzw. Ka', Kc', welche durch wechselseitiges Ausblenden aus den Systemtaktsignalen k1', k2 gebildet werden, ist somit gleich der Datenrate. Bei einer ausgeführten Schaltung betrug die Datenrate 7 MHz. Die daraus und aus dem Systemtaktsignalen k1, k2 durch geringen Schaltungsaufwand mittels Ausblendung gewonnenen Abtastsignale Ka', Kc' koinzidieren seltener mit den Taktflanken des Datensignals als es bei Taktsignalen grösserer Breite der Fall ist. Da zu einer monolithischen Integration sowohl für die Schaltungsanordnung nach der Erfindung als auch bei der Anwendung gemäss dem Ausführungsbeispiel ein relativ geringer Flächenaufwand erforderlich ist, kann ohne erheblichen Mehraufwand an Kristallfläche eine monolithische Integration auf jeder VLSI-Schaltung eines Systems von VLSI-Schaltungen erfolgen.

**Patentansprüche**

1. Integrierbare Schaltungsanordnung zur Gewinnung von Koinzidenzimpulsen beim Auftreten der Koinzidenz der abfallenden Impulsflanken eines digitalen Datensignals (De) mit den abfallenden Flanken von auf einer Taktleitung (T1) liegenden Abtastsignalen (Ka', Kc'), welche zur Steuerung eines digitalen Datenverarbeitungssystems aus einem zweiphasigen Systemtakt (k1, k2) abgeleitet sind, dadurch gekennzeichnet,
— dass die Taktleitung (T1) mit dem ersten Eingang eines aus zwei kreuzgekoppelten NOR-Gattern (a, b) bestehenden Eingangsgatters verbunden ist, an dessen zweitem Eingang das eine Systemtaktsignal (k1) des zweiphasigen Systemtakts (k1, k2) liegt,
— dass die Verzögerungszeit des ersten NOR-Gatters (b), an dem das Abtastsignal (Ka' bzw. Kc') liegt, grösser ist als die Verzögerungszeit des anderen zweiten NOR-Gatters (a),
— dass der Ausgang des zweiten NOR-Gatters (a) entweder über einen Inverter (I1) mit dem ersten Eingang eines drei Eingänge aufweisenden dritten NOR-Gatters (c) oder unmittelbar mit dem ersten Eingang eines drei Eingänge aufweisenden AND-Gatters verbunden ist, und
— dass am zweiten Eingang des dritten NOR-Gatters (C) bzw. des AND-Gatters das Datensignal (De) und an dessen drittem Eingang das invertierte Datensignal über ein Verzögerungsglied liegt.

2. Integrierbare Schaltungsanordnung nach Anspruch 1, dadurch gekennzeichnet, dass das Abtastsignal (Ka', Kc') durch wechselseitiges Ausblenden von Impulsen aus den Systemtaktsignalen (k1, k2) gebildet ist, deren Frequenz gleich dem Zweifachen der Datenrate ist.

3. Integrierte Schaltungsanordnung nach den Ansprüchen 1 und 2, dadurch gekennzeichnet, dass der Koinzidenzimpuls am ersten Eingang eines vierten NOR-Gatters (d) mit drei Eingängen liegt, welches mit einem fünften NOR-Gatter (e) ein erstes Speicherflipflop (L1) bildet, wobei an einen Eingang des vierten NOR-Gatters (d) ein Setzsignal (SET) und an einem Eingang des fünften NOR-Gatters (e) ein Rücksetzsignal (B) liegt und am Ausgang des vierten NOR-Gatters (d) ein Aktivierungssignal (A) für einen Phasendetektor (Pd) abgreifbar ist.

4. Integrierte Schaltungsanordnung nach Anspruch 3, dadurch gekennzeichnet, dass der Phasendetektor (Pd) mehrere in ihren Laufzeiten abgestufte und vom Systemtakt (k1, k2) getaktete Verzögerungsleitungen enthält, welche ein erstes Paar von Verzögerungsleitungen relativ kleiner Laufzeiten und ein zweites Paar von Verzögerungsleitungen relativ grosser Laufzeiten bilden.

5. Integrierte Schaltungsanordnung nach Anspruch 4, dadurch gekennzeichnet,
— dass jedes Paar eine Verzögerungsleitung enthält, an deren Eingang das Datensignal über einen vom ersten Systemtakt (k1) leitend gesteuerten Schalter anlegbar ist, und eine weitere Verzögerungsleitung gleicher Verzögerungszeit aufweist, an deren Eingang das Datensignal über einen vom zweiten Systemtakt (k2) leitend gesteuerten Schalter anlegbar ist, und

— dass das Aktivierungssignal (A) an je einem Eingang eines von zwei Gattern (h, i) mit je drei Eingängen liegt, wobei an den weiteren Eingängen des ersten Gatters (h) je ein Ausgang einer Verzögerungsleitung des ersten Paars und an den weiteren Eingängen des zweiten Gatters (i) je ein Ausgang einer Verzögerungsleitung des zweiten Paars liegt.

6. Integrierte Schaltungsanordnung nach Anspruch 5, dadurch gekennzeichnet, dass diejenigen Verzögerungsleitungen, welche das Datensignal gleichzeitig mit demselben Systemtakt (k1 bzw. k2) erhalten, durch angezapfte Verzögerungsleitungen realisiert sind.

7. Integrierte Schaltungsanordnung nach einem der Ansprüche 4 bis 6, dadurch gekennzeichnet,
— dass das Datensignal am Eingang einer ersten Verzögerungsleitung (Vz1) über einen ersten Schalter liegt, welcher vom ersten Systemtakt (k1) leitend gesteuert ist, und am Eingang einer zweiten Verzögerungsleitung (Vz2) von gleicher Verzögerungszeit wie die der ersten Verzögerungsleitung (Vz1) über einen zweiten, vom zweiten Systemtakt (k2) leitend gesteuerten Schalter liegt,
— dass das Datensignal über einen vom ersten Systemtakt (k1) leitend gesteuerten Schalter am Eingang einer dritten Verzögerungsleitung (Vz3) mit einer um eine Taktperiode grösseren Verzögerungszeit als die Verzögerungszeit der ersten bzw. zweiten Verzögerungsleitung liegt,
— dass die Ausgangssignale der ersten Verzögerungsleitung (Vz1) und invertiert die der zweiten Verzögerungsleitung (Vz2) über je einen vom ersten Systemtakt (k1) leitend gesteuerten Schalter am ersten Eingang bzw. zweiten Eingang eines sechsten NOR-Gatters (h) mit drei Eingängen und die Ausgangssignale der zweiten Verzögerungsleitung (Vz2) und invertiert die der dritten Verzögerungsleitung (Vz3) über je einen ebenfalls vom ersten Systemtakt (k1) leitend gesteuerter Schalter am ersten bzw. zweiten Eingang eines siebten NOR-Gatters (i) mit drei Eingängen sowie das Aktivierungssignal (A) an den ersten Eingängen des sechsten und siebten NOR-Gatters (h, i) liegen.

8. Integrierte Schaltungsanordnung nach einem der Ansprüche 5 bis 7, dadurch gekennzeichnet,
— dass die Ausgänge des sechsten und des siebten NOR-Gatters (h, i) über je einen von ersten Taktimpulsen (KA) leitend gesteuerten Schalter mit den beiden Eingängen eines ersten NOR-Eingangsgatters (j) eines Auswahlschaltkreises (As) und über je einen von zweiten Taktimpulsen (KC) leitend gesteuerten Schalter mit den beiden Eingängen eines zweiten NOR-Eingangsgatters (m) des Auswahlschalters (As) verbunden sind, wobei die Taktimpulse (KA, KC) durch wechselseitiges Ausblenden aus dem Signaltakt (k1, k2) gebildet sind,
— dass das Ausgangssignal des ersten NOR-Eingangsgatters (j) über einen vom ersten Systemtakt (k1) leitend gesteuerter Schalter am Eingang eines Inverters (I12) liegt, dessen Ausgang über einen zweiten Systemtakt (k2) leitend gesteuerten Schalter mit dem ersten Eingang eines zweiten Speicherflipflops verbunden ist,
— dass das Ausgangssignal des zweiten NOR-Eingangsgatters (m) über einen vom ersten Systemtakt (k1) leitend gesteuerter Schalter am Eingang eines weiteren Inverters (I13) liegt, dessen Ausgang über einen vom zweiten Systemtakt (k2) leitend gesteuerten Schalter mit dem zweiten Eingang des zweiten Speicherflipflops (L2) verbunden ist, das zwei kreuzgekoppelte NOR-Gatter (o, p) enthält und zur Auswahl eines von zwei Abtastsignalen (Ka', Kc') ein erstes Ausgangssignal (E) an seinem ersten Ausgang und ein zweites dazu invertiertes Ausgangssignal (D) an seinem zweiten Ausgang zur Verfügung stellt, und
— dass die Ausgänge des ersten und zweiten NOR-Eingangsgatters (j, m) mit je einem Eingang eines NAND-Gatters (N3) verbunden sind, dessen Ausgang das Rücksetzsignal (B) für das fünfte NOR-Gatter (e) zur Verfügung stellt.

9. Integrierte Schaltungsanordnung nach Anspruch 8, dadurch gekennzeichnet,
— dass jedes der beiden Ausgangssignale (E, D) den Eingangsschaltkreis (q, r) einer vierten und einer fünften Verzögerungsleitung (Vz4, Vz5) ansteuert, an der entsprechend dem zugeordneten Ausgangssignal (E, D) ein Basis-Taktsignal (Ck1, Ck2) eines zweiphasigen Basistaktes liegt, der aus dem Systemtakt (k1, k2) durch Frequenzteilung abgeleitet ist,
— dass der jeweilige Ausgang jeder dieser beiden Verzögerungsleitungen an der Gateelektrode des Lasttransistors eines Ausgangsinverters liegt, zu dessen Spannungsversorgung der zweite Systemtakt (k2) dient und dessen Schalttransistor vom ersten Systemtakt (k1) angesteuert ist sowie dessen Ausgang mit der Taktleitung (Tl) verbunden ist, und
— dass jeweils einer der beiden Abtastimpulse (Ka', Kc') in gleicher Weise durch wechselseitige Ausblendung aus dem Systemtakt (k1, k2) mittels einer Ausblendschaltung gebildet ist, welche eine sechste Verzögerungsleitung (Vz6) und eine siebte Verzögerungsleitung (Vz7) enthält, welche die gleichen Verzögerungszeiten und den gleichen Ausgangsinverter aufweisen wie die vierte und fünfte Verzögerungsleitung (Vz4, Vz5) der Ausblendschaltung zur Bildung der Taktimpulse (KA, KC), die zur Ansteuerung der an den Ausgängen des Phasendetektors (Pd) liegenden Schalter Verwendung finden.

## Claims

1. Integrable circuit arrangement for deriving coincidence pulses on coincidences of the falling edges of pulses of a data signal (De) with the falling edges of pulses of sampling signals (Ka', Kc') which are present on a clock line (Tl) and are derived from a two-phase system clock (k1, k2) for the purpose of controlling a digital data processing system, characterized in
— that the clock line (Tl) is connected to the first input of an input gate which consists of two cross-coupled NOR gates (a, b) and whose second input is presented with one of the signals (k1) of the two-phase system clock (k1, k2),

— that the delay introduced by the first NOR gate (b), to which the sampling signal (Ka', Kc') is applied, is longer than the delay introduced by the other, second NOR gate (a),

— that the output of the second NOR gate (a) is connected either via an inverter (I1) to the first input of a three-input third NOR gate (c) or directly to the first input of a three-input AND gate, and

— that the second input of the third NOR gate (c) or of the AND gate is presented with the data signal (De), while the third input of this gate is fed with the inverted data signal via a delay element.

2. An integrable circuit arrangement as claimed in claim 1, characterized in that the sampling signal (Ka', Kc') is formed by alternate selection of pulses from the system-clock signals (k1, k2), whose frequency is equal to twice the data rate.

3. An integrable circuit arrangement as claimed in claims 1 and 2, characterized in that the coincidence pulse is applied to the first input of a three-input fourth NOR gate (d) which forms a first latch flip-flop (L1) with a fifth NOR gate (e), that one of the inputs of the fourth NOR gate (d) and one of the inputs of the fifth NOR gate (e) fed with a set signal (SET) and a reset signal (B), respectively, and that the output of the fourth NOR gate (d) provides an enable signal (A) for a phase detector (Pd).

4. An integrable circuit arrangement as claimed in claim 3, characterized in that the phase detector (Pd) contains several delay lines which provide different delays, are clocked by the system clock (k1, k2), and form a first pair of delay lines providing relatively short delays and a second pair of delay lines providing relatively long delays.

5. An integrable circuit arrangement as claimed in claim 4, characterized in

— that each of the pairs contains a delay line whose input can be fed with the data signal via a switch rendered conductive by the first system clock (k1), and another delay line which provides the same delay and whose input can be fed with the data signal via a switch rendered conductive by the second system clock (k2), and

— that the enable signal (A) is applied to one input of each of two three-input gates (h, i), with the other inputs of the first gate (h) each connected to the output of one of the delay lines of the first pair, and the other inputs of the second gate (i) each connected to the output of one of the delay lines of the second pair.

6. An integrable circuit arrangement as claimed in claim 4 or 5, characterized in that the delay lines which receive the data signals simultaneously on the same pulse of the system clock (k1, k2) are implemented with tapped delay lines.

7. An integrable circuit arrangement as claimed in any one of claims 4 to 6, characterized in

— that the data signal is applied to the input of a first delay line (Vz1) via a first switch rendered conductive by the first system clock (k1), and to the input of a second delay line (Vz2) via a second switch rendered conductive by the second system clock (k2), the second delay line (Vz2) producing the same delay as the first delay line (Vz1),

— that the data signal is applied via a switch rendered conductive by the first system clock (k1) to the input of a third delay line whose delay is one clock period longer than that of the first or second delay line, and

— that the output signal of the first delay line (Vz1) and the inverted output signal of the second delay line (Vz2) are applied, respectively, to the first input and the second input of a three-input sixth NOR gate (h) through switches rendered conductive by the first system clock (k1), while the output signal of the second delay line (Vz2) and the inverted output signal of the third delay line (Vz3) are applied, respectively, to the first input and the second input of a three-input seventh NOR gate (i) via switches rendered conductive by the first system clock (k1), and that the enable signal (A) is applied to the third inputs of the sixth and seventh NOR gates (h, i).

8. An integrable circuit arrangement as claimed in any one of claims 5 to 7, characterized in

— that the outputs of the sixth and seventh NOR gates (h, i) are each connected via a switch rendered conductive by first clock pulses (KA) to one of the two inputs of a first NOR input gate (j) of a selection circuit (As) and via a switch rendered conductive by second clock pulses (KC) to one of the two inputs of a second NOR input gate (m) of the selection circuit (As), the clock pulses (KA, KC) being formed by alternate gating from the system clock (k1, k2),

— that the output signal of the first NOR input gate (j) is applied through a switch rendered conductive by the first system clock (k1) to the input of an inverter (I12) having its output connected via a switch rendered conductive by a second system clock (k2) to the first input of a second latch flip-flop,

— that the output signal of the second NOR input gate (m) is applied through a switch rendered conductive by the second system clock (k2) to the second input of the second latch flip-flop (L2), which contains two cross-coupled NOR gates (o, p) and makes a first output signal (E) and a second, inverted input signal (D) available at its first output and its second output respectively, for the selection of one of two sampling signals (Ka', Kc'), and

— that the outputs of the first and second NOR input gates (j, m) of said selection circuit (As) are each connected to one of the inputs of a NAND gate (N3) whose output provides the reset signal (B) for the fifth NOR gate (e).

9. An integrable circuit arrangement as claimed in claim 8, characterized in

— that each of the two output signals (E, D) controls the input circuit (q, r) of a fourth delay line (Vz4) and a fifth delay line (Vz5) to which a basic clock signal (Ck1, Ck2) of a two-phase basic clock derived from the system clock (k1, k2) by frequency division is applied according to the assigned output signal (E, D),

— that the output of each of these two delay lines is connected to the gate electrode of the load transistor of an output inverter whose voltage supply is constituted by the second system clock (k2), whose switching transistor is driven with the first system clock (k1), and whose output is connected to the clock line (TI), and

— that each of the two sampling pulses (Ka', Kc') is formed by alternate gating from the system clock (k1, k2) by means of a gating circuit containing a sixth delay line (Vz6) and a seventh delay line (Vz7) which each produce the same delay and have the same output inverter as the fourth and fifth delay lines (Vz4, Vz5) of the gating circuit for forming the clock pulses (KA, KC) used to control the switches at the outputs of the phase detector (Pd).

## Revendications

1. Agencement de circuits intégrable pour produire des impulsions de coïncidence en cas de coïncidence entre les flancs d'impulsion arrière d'un signal numérique de donnée (De) et les flancs arrière de signaux d'échantillonnage (Ka', Kc') qui se trouvent sur une ligne de synchronisation (T1) et qui, pour commander un système numérique de traitement de données, sont dérivées de signaux de synchronisation à deux phases (k1, k2), caractérisé en ce que la ligne de synchronisation (T1) est connectée à la première entrée d'une porte d'entrée qui est constituée de deux portes NON-OU couplées en croix (a, b) et à la seconde entrée de laquelle est appliqué un signal de synchronisation (k1) de l'impulsion des signaux de synchronisation à deux phases (k1, k2), en ce que le temps de retard de la première porte NON-OU (b), à laquelle le signal d'échantillonnage (Ka' ou, respectivement, Kc') est appliqué, est supérieur au temps de retard de la seconde porte NON-OU (a), en ce que la sortie de la deuxième porte NON-OU (a) est connectée soit, par l'intermédiaire d'un inverseur (I1), à la première entrée d'une troisième porte NON-OU à trois entrées (c), soit directement à la première entrée d'une porte ET à trois entrées, et en ce qu'à la deuxième entrée de la troisième porte NON-OU (c) ou, respectivement, de la porte ET est appliqué le signal de donnée (De) et à sa troisième entrée est appliqué le signal de donnée inversé par l'intermédiaire d'un élément de retard.

2. Agencement de circuits intégrable suivant la revendication 1, caractérisé en ce que le signal d'échantillonnage (Ka', Kc') est formé par échantillonnage réciproque d'impulsions provenant des signaux de synchronisation (k1, k2) dont la fréquence est égale au double du débit de données.

3. Agencement de circuits intégrable suivant les revendications 1 et 2, caractérisé en ce que l'impulsion de coïncidence est appliquée à la première entrée d'une quatrième porte NON-OU (d) à trois entrées qui forme, avec une cinquième porte NON-OU (e), une première bascule de mémorisation (I1), un signal d'établissement (SET) étant appliqué à une entrée de la quatrième porte NON-OU (d) et un signal de remise à l'état initial (B) étant appliqué à une entrée de la cinquième porte NON-OU (e), et un signal d'activation (A) d'un détecteur de phase (Pd) pouvant être prélevé à la sortie de la quatrième porte NON-OU (d).

4. Agencement de circuits intégrable suivant la revendication 3, caractérisé en ce que le détecteur de phase (Pd) comporte plusieurs lignes de retard dont les temps de fonctionnement sont étagés, qui sont synchronisées par des signaux de synchronisation (k1, k2) et qui forment une première paire de lignes de retard à temps de fonctionnement relativement courts et une seconde paire de lignes de retard à temps de fonctionnement relativement longs.

5. Agencement de circuits intégrable suivant la revendication 4, caractérisé en ce que chaque paire comporte une ligne de retard, à l'entrée de laquelle peut être appliqué un signal de donnée par l'intermédiaire d'un commutateur commandé à l'état conducteur par un premier signal de synchronisation (k1), et comporte une autre ligne de retard de temps de retard identique, à l'entrée de laquelle le signal de donnée peut être appliqué par l'intermédiaire d'un commutateur commandé à l'état conducteur par un second signal de synchronisation (k2), et en ce que le signal d'activation (A) est appliqué à l'une des entrées d'une des deux portes (h, i) à trois entrées, aux autres entrées de la première porte (h) étant appliquée une sortie d'une ligne de retard de la première paire et aux autres entrées de la seconde porte (i) étant appliquée une sortie d'une ligne de retard de la deuxième paire.

6. Agencement de circuits intégrable suivant la revendication 5, caractérisé en ce que les lignes de retard, qui reçoivent le signal de donnée simultanément à l'impulsion de synchronisation (k1 ou, respectivement, k2), sont réalisées par des lignes de retard à prise.

7. Agencement de circuits intégrable suivant l'une quelconque des revendications 4 à 6, caractérisé en ce que le signal de donnée est appliqué à l'entrée d'une première ligne de retard (Vz1) par l'intermédiaire d'un premier commutateur qui est commandé à l'état conducteur par le premier signal de synchronisation (k1), et à l'entrée d'une deuxième ligne de retard (Vz2) à temps de retard identique à celui de la première ligne de retard (Vz1) par l'intermédiaire d'un second commutateur commandé à l'état conducteur par la deuxième impulsion de synchronisation (k2), en ce que le signal de donnée est appliqué, par l'intermédiaire d'un commutateur commandé à l'état conducteur par la première impulsion de synchronisation (k1), à l'entrée d'une troisième ligne de retard (Vz3) avec un temps de retard supérieur d'une période de synchronisation au temps de retard des première et, respectivement, seconde lignes de retard, en ce que les signaux de sortie de la première ligne de retard (Vz1) et, de manière inversée, ceux de la deuxième ligne de retard (Vz2) sont appliqués, par l'intermédiaire d'un commutateur commandé à l'état conducteur par le premier signal de synchronisation (k1), à la première entrée ou, respectivement, à la deuxième entrée d'une sixième porte NON-OU (h) à trois entrées, les signaux de sortie de la deuxième ligne de retard (Vz2) et, de manière inversée, ceux de la troisième ligne de retard (Vz3) sont appliqués, par l'intermédiaire d'un commutateur également commandé à l'état conducteur par la première impulsion de synchronisation (k1), à la première ou, respectivement, à la deuxième entrée d'une septième porte NON-OU (i) à trois entrées, et le signal d'activation (A) est appliqué aux premières entrées des sixième et septième portes NON-OU (h, i).

8. Agencement de circuits intégrable suivant l'une quelconque des revendications 5 à 7, caractérisé en ce que les sorties des sixième et septième portes NON-OU (h, i) sont connectées, par l'intermédiaire d'un commutateur commandé à l'état conducteur par des premières impulsions de synchronisation (KA), aux deux entrées d'une première porte d'entrée NON-OU (j) d'un circuit de sélection (As) et, par l'intermédiaire d'un commutateur commandé à l'état conducteur par des deuxièmes impulsions de synchronisation (KC), aux deux entrées d'une deuxième porte d'entrée NON-OU (m) du commutateur de sélection (As), les impulsions de synchronisation (KA, KC) étant formées par échantillonnage réciproque à partir de l'impulsion de synchronisation (k1, k2), en ce que le signal de sortie de la première porte d'entrée NON-OU (j) est appliqué, par l'intermédiaire d'un commutateur commandé à l'état conducteur par la première impulsion de synchronisation (k1), à l'entrée d'un inverseur (I12) dont la sortie est connectée, par l'intermédiaire d'un commutateur commandé à l'état conducteur par la deuxième impulsion de synchronisation (k2), à la première entrée d'une deuxième bascule de mémorisation, en ce que le signal de sortie de la deuxième porte d'entrée NON-OU (m) est appliqué, par l'intermédiaire d'un commutateur commandé à l'état conducteur par la première impulsion de synchronisation (k1), à l'entrée d'un autre inverseur (I13) dont la sortie est connectée, par l'intermédiaire d'un commutateur commandé à l'état conducteur par la deuxième impulsion de synchronisation (k2), à la deuxième entrée de la deuxième bascule de mémorisation (L2) qui comprend deux portes NON-OU couplées en croix (o, p) et qui, pour sélectionner l'un des deux signaux d'échantillonnage (Ka', Kc'), fournit un premier signal de sortie (E) à sa première sortie et un deuxième signal de sortie (D), inversé par rapport au premier, à sa deuxième sortie, et en ce que les sorties des première et deuxième portes d'entrée NON-OU (j, m) sont connectées à une entrée d'une porte NON-ET (N3) dont la sortie fournit le signal de remise à l'état initial (B) de la cinquième porte NON-OU (e).

9. Agencement de circuits intégrable suivant la revendication 8, caractérisé en ce que chacun des deux signaux de sortie (E, D) commande le circuit d'entrée (q, r) d'une quatrième et d'une cinquième ligne de retard (Vz4, Vz5) à laquelle est appliqué, selon le signal de sortie correspondant (E, D), un signal de synchronisation de base (Ck1, Ck2) d'une impulsion de base à deux phases dérivée des signaux de synchronisation (k1, k2) par division de fréquence, en ce que la sortie de chacune desdites deux lignes de retard est appliquée à l'électrode de grille du transistor de charge d'un inverseur de sortie à l'alimentation en tension duquel sert le deuxième signal de synchronisation (k2), dont le transistor de commande est commandé par le premier signal de synchronisation (k1) et dont la sortie est connectée à la ligne de synchronisation (TI), et en ce que l'une des deux impulsions d'échantillonnage (Ka', Kc') est également formée par échantillonnage réciproque à partir des signaux de synchronisation (k1, k2) au moyen d'un circuit d'échantillonnage qui comprend une sixième ligne de retard (Vz6) et une septième ligne de retard (Vz7) qui ont les mêmes temps de retard et les mêmes inverseurs de sortie que les quatrième et cinquième lignes de retard (Vz4, Vz5) du circuit d'échantillonnage pour former les impulsions de synchronisation (KA, KC) qui sont utilisées pour commander les commutateurs implantés au niveau des sorties du détecteur de phase (Pd).

FIG. 1

EP 0 246 351 B1

# FIG.2

# FIG.3

EP 0 246 351 B1

FIG. 4

FIG. 5

FIG. 6

EP 0 246 351 B1

FIG.7

17